Europäisches Patentamt

European Patent Office

Office européen des brevets

(19)

(11) Publication number: **0 317 963**
**A2**

# EUROPEAN PATENT APPLICATION

(21) Application number: 88119434.4

(22) Date of filing: 22.11.88

(51) Int. Cl.4: **G11C 7/00 , G11C 11/24**

(30) Priority: 25.11.87 JP 295114/87

(43) Date of publication of application:
**31.05.89 Bulletin 89/22**

(84) Designated Contracting States:
**DE FR IT**

(71) Applicant: **KABUSHIKI KAISHA TOSHIBA**
**72, Horikawa-cho Saiwai-ku**
**Kawasaki-shi Kanagawa-ken 210(JP)**

(72) Inventor: **Kobayashi, Takayuki c/o Patent**
**Division**
**Kabushiki Kaisha Toshiba 1-1 Shibaura**
**1-chome**
**Minato-ku Tokyo 105(JP)**
Inventor: **Oowaki, Yukihito c/o Patent Division**
**Kabushiki Kaisha Toshiba 1-1 Shibaura**
**1-chome**
**Minato-ku Tokyo 105(JP)**
Inventor: **Sakui, Koji c/o Patent Division**
**Kabushiki Kaisha Toshiba 1-1 Shibaura**
**1-chome**
**Minato-ku Tokyo 105(JP)**
Inventor: **Itoh, Yasuo c/o Patent Division**
**Kabushiki Kaisha Toshiba 1-1 Shibaura**
**1-chome**
**Minato-ku Tokyo 105(JP)**
Inventor: **Watanabe, Shigeyoshi c/o Patent**
**Division**
**Kabushiki Kaisha Toshiba 1-1 Shibaura**
**1-chome**
**Minato-ku Tokyo 105(JP)**

(74) Representative: **Henkel, Feiler, Hänzel &**
**Partner**
**Möhlstrasse 37**
**D-8000 München 80(DE)**

(54) Semiconductor memory device having dRAM cells.

(57) Data of "0" and "1" are input to input pad (10) which is provided for each dRAM chip. The data is input to two data input buffers (14a, 14b) via protection circuit 12. Each of data input buffers (14a, 14b) senses the level of input data, converts the sensed level to the MOS level and outputs the MOS level data. Data input buffers (14a, 14b) are respectively supplied with control signals ($\phi$a, $\phi$b) for determining the sense-timings thereof. The phases of control signals ($\phi$a, $\phi$b) are shifted from each other. Selection circuit (16) selects an output of one of data input buffers (14a, 14b) in synchronism with control signals ($\phi$a, $\phi$b) and supply the selected output to a corresponding one of write data line (18). Since two data input buffers are used, each data input buffer may operate to sense every other input data and

each of control signals ($\phi$a, $\phi$b) is set to have a pulse occurring in every two cycles of the input data.

F I G. 2

## Semiconductor memory device having dRAM cells

This invention relates to a semiconductor memory device having a dynamic random access memory (dRAM) and more particularly to the improvement of a data write-in circuit thereof.

As the miniaturization technique has advanced, the integration density of the dRAM becomes high, and the performance of the semiconductor element is enhanced by the miniaturization, causing the access time of the dRAM to be made shorter. Further, in order to apply the dRAM in the field of, for example, image processing in which a large amount of data is required to be read and written at an extremely high speed, it is increasingly required to make the operation speed of the dRAM higher.

Further, while the operation speed of the dRAM itself is made high, various functions are extensively improved, and for example, the number of input/output bits is increased and operation modes are diversified. In this case, various modes such as the page mode, nibble mode and static column mode have been developed to achieve the high speed readout/write-in of data with respect to a plurality of member cells connected to a selected one of the word lines. In order to meet the high speed operation, it is necessary to precisely write external data into the internal memory cell at a higher speed.

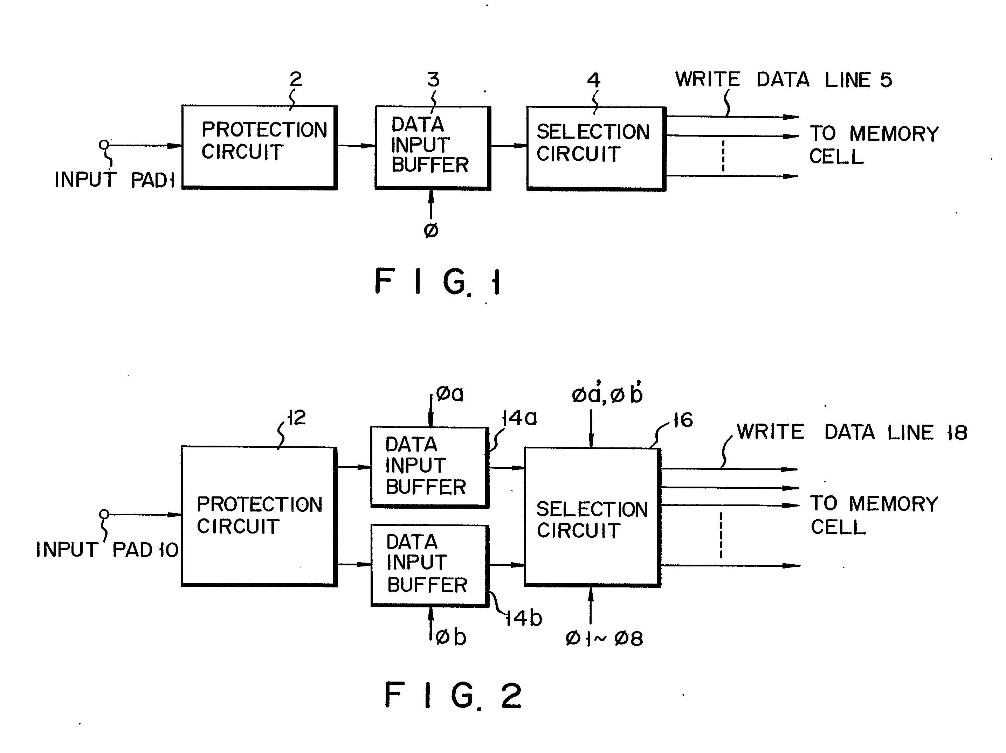

Now, the operation of writing data into the internal memory cell of the conventional dRAM is explained with reference to Fig. 1. Data of "0" or "1" is supplied in a bit-serial fashion to input pad 1 which is generally provided for each dRAM chip. The data is supplied to data input buffer 3 via protection circuit 2. Since the input data is set at a TTL level, data input buffer 3 converts the sensed level of input data to the MOS level and then outputs the converted data. Control signal $\phi$ is used to determine the sense-timing (more precisely, timing at which data can be output after the sense operation is completed). When control signal $\phi$ is supplied, sensed data is output from data input buffer 3 and supplied to selection circuit 4. Selection circuit 4 supplies the received data to any one of write data lines 5, and the data is written into a memory cell (not shown).

In a case where new data is continuously written in a relatively short period of time and if the sensing speed of data input buffer 3 is low, the operation thereof cannot precisely follow variation in the input data and therefore data input buffer 3 cannot correctly sense the data. That is, error data may be written into the dRAM, causing the dRAM to erroneously operate. In this way, even when an attempt to attain a higher operation speed and particularly a higher write-in operation speed is made in the conventional dRAM, the operation speed of the data input buffer prevents the operation speed of the conventional dRAM from being made higher.

An object of this invention is to provide a semiconductor memory device having a dRAM in which input data can be correctly sensed at a high speed and data can be written at a high speed.

Another object of this invention is to enhance the sensing speed of a data input buffer in the write-in circuit of a semiconductor memory device without enhancing the sensitivity thereof.

According to this invention, there is provided a semiconductor memory device comprising a plurality of data input buffers for sensing input data and connected in parallel with a data input pad; means for sequentially supplying control signals to the plurality of data input buffers to determine the sense-timing; and selection means for receiving outputs from the plurality of data input buffers, selecting one of the received outputs and supplying the selected one of the outputs to a write data line.

This invention can be more fully understood from the following detailed description when taken in conjunction with the accompanying drawings, in which:

Fig. 1 is a block diagram of a write-in circuit of the conventional semiconductor memory device;

Fig. 2 is a block diagram of a write-in circuit of a semiconductor memory device according to one embodiment of this invention;

Fig. 3 is a timing chart showing the operation of a data input buffer;

Fig. 4 is a circuit diagram of the data input buffer;

Fig. 5 is a circuit diagram of a selection circuit;

Fig. 6 is a circuit diagram of a clocked inverter;

Fig. 7 is a timing chart showing the operation of the selection circuit; and

Fig. 8 is a diagram showing the memory section of a dRAM to which the embodiment of this invention is applied.

There will now be described a semiconductor memory device according to an embodiment of this invention. Fig. 2 is a block diagram of a write-in circuit in the embodiment. Data "0" or "1" is input in bit-serial fashion to input pad 10 which is generally provided for each dRAM. The input data is supplied to two data input buffers 14a and 14b via protection circuit 12. Data input buffers 14a and 14b sense the TTL level of the input data, converts the sensed TTL level to the MOS level, and output data of the MOS level. Data input buffers 14a and 14b are respectively supplied with control signals φa and φb which are used to determine the sense-timings thereof and whose phases are shifted from each other. Selection circuit 16 selects one of outputs of data input buffers 14a and 14b in synchronism with control signals φa′ and φb′ and supplies the selected output to one of write data lines 18.

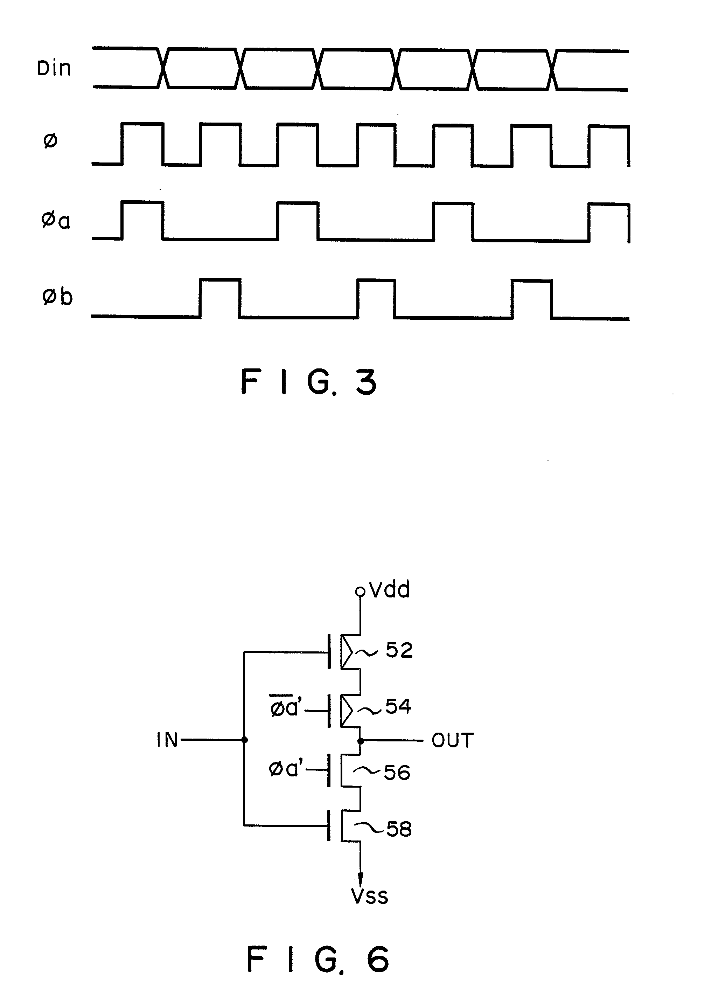

Fig. 3 shows the timing of control signals φa and φb. As shown in Fig. 1, since only one data input buffer is provided in the prior art, the data input buffer will have to effect the sensing operation in the same cycle as input data Din and therefore it is necessary to set control signal φ in the same cycle as the input data. In this case, the "L" level period of control signal φ is set as the data sensing period, and the "H" level period thereof is set as the period for supplying the sensed data to selection circuit 16. That is, the "H" level pulse period is used as a data transfer pulse period.

In contrast, since two data input buffers are provided in this embodiment, it is only required for each data input buffer to sense every other input data and it is only necessary for each of control signals φa and φb to have a "H" level transfer pulse occurring once for every two cycles of the input data. In this way, the operation cycle of the data input buffer is set equal to one-half that of input data Din, and therefore even if the cycle of input data Din is set shorter, the data input buffer can be precisely operated in response to variation in input data, thus attaining a high speed write-in operation. Further, in a case where the cycle of the input data is kept unchanged, the sensing speed of data input buffers 14a and 14b is set to be one-half that of the conventional data input buffer and therefore the operation margin thereof can be improved.

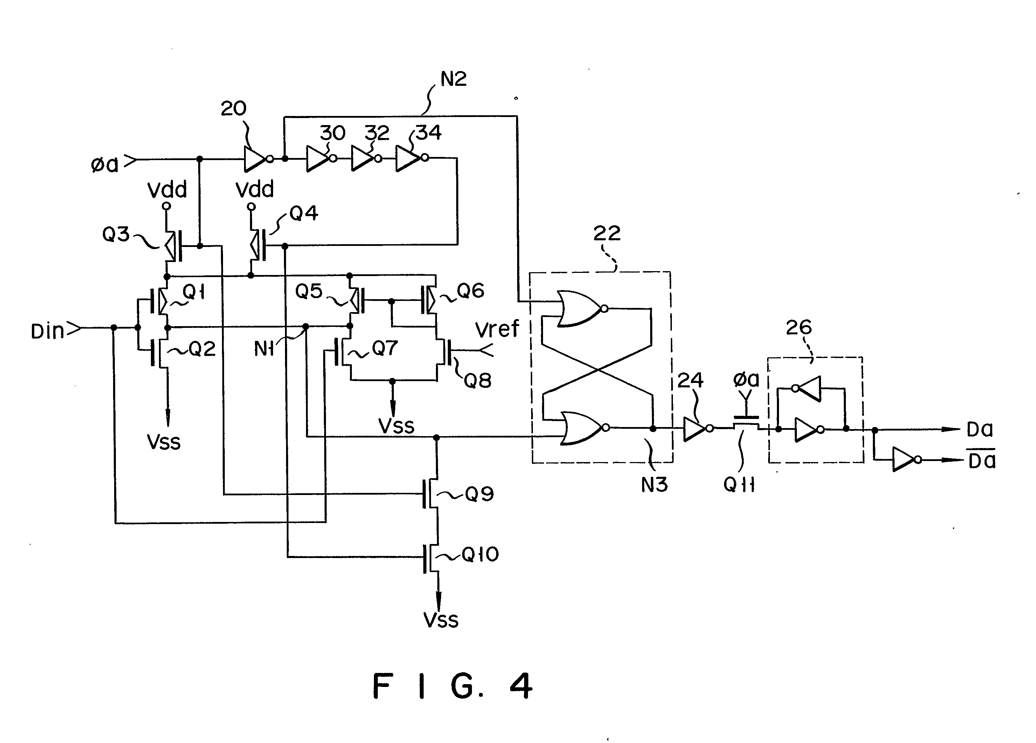

Fig. 4 is a block diagram showing an example of data input buffer 14a. Data input buffer 14b is formed and operated in the same manner. Input data Din of TTL level ("L" level ≦ 0.8 V, and "H" level ≧ 2.4 V) is supplied to the commonly connected gates of p-channel MOSFET Q1 and n-channel MOSFET Q2. When input data Din is equal to or higher than 2.4 V ("H" level), the potential at source-drain connection node N1 between MOSFETs Q1 and Q2 is set to be "L" level. MOSFET Q1 is connected to power source Vdd (5 V) via parallel-connected p-channel MOSFETs Q3 and Q4 as loads.

Source-drain connection node N1 between MOSFETs Q1 and Q2 is connected to a current mirror circuit which is constituted by p-channel MOSFETs Q5 and Q6 and n-channel MOSFETs Q7 and Q8. Input data Din is also supplied to the gate of MOSFET Q7 and reference potential Vref (1.6 V) is applied to the gate of MOSFET Q8. In this case, since input data Din is set equal to or higher than 2.4 V, MOSFET Q7 is turned on, causing the potential level of node N1 to be stably set at ground voltage Vss (0 V). In this way, the input data is sensed by stably setting the potential level of node N1.

After the sufficient sensing operation is completed, control signal φa is set to "H" level. As a result, output node N2 of inverter 20 is set to "L" level (MOS level), thereby setting output node N3 of flip-flop 22 to "H" level (MOS level). The output data of flip-flop 22 is supplied to latch circuit 26 via inverter 24 and transfer gate Q11 formed of an n-channel MOSFET, and thus "H" level (MOS level) data is latched. As a result, the sensed data is transferred to the selection circuit. Further, since input data Din is set equal to or higher than 2.4 V, output signal Da is set to "H" level of MOS level, and D̄a is set to "L" level. In contrast, when input data Din is set equal to or lower than 0.8 V, output signals Da and D̄a are set to "L" and "H" levels, respectively.

When a preset period of time determined by a delay circuit constituted by series-connected inverters 20, 30, 32 and 34 has passed after control signal φa was set to "H" level, the gate potential of MOSFET Q10 is set to "H" level to turn on MOSFET Q10. Since MOSFET Q9 has been turned on in response to the rise of φa, node N1 is grounded and set to "L" level. Thus, the sensed data is reset.

As described above, the sensed data is transferred in response to the transfer pulse of control signal φa. Since, in this case, the transfer pulses of control signals φa and φb are out of phase from each other, paired output signals, Da, D̄a and Db, D̄b are successively output in partly overlapped fashion from data input buffers 14a and 14b.

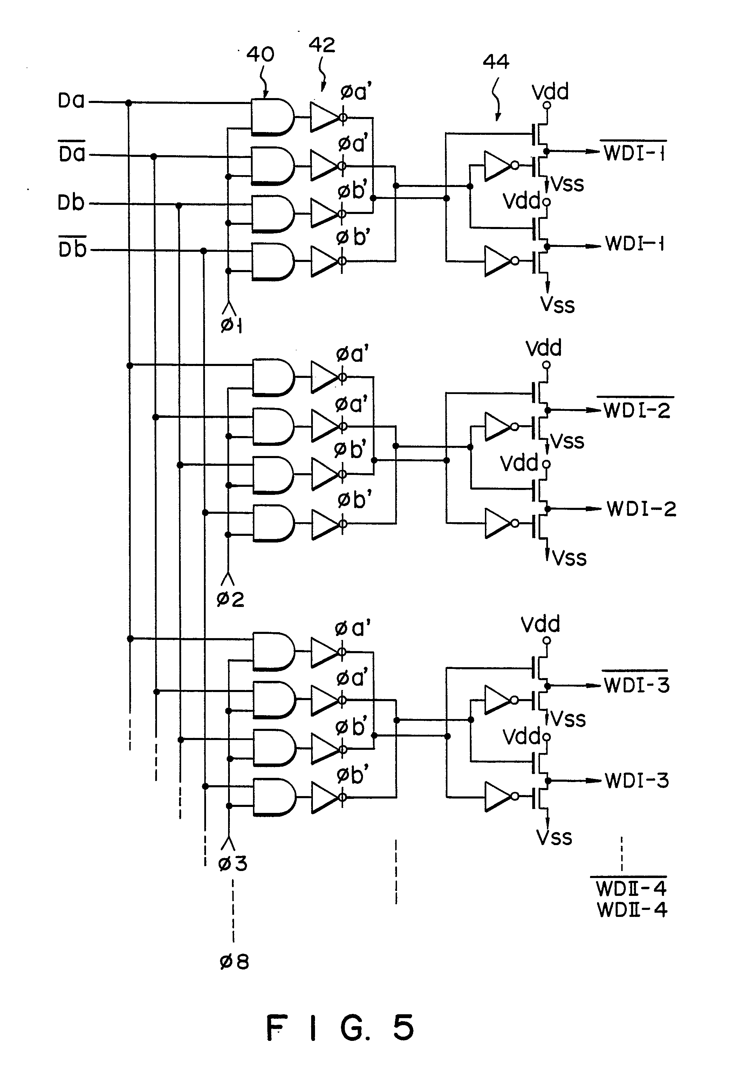

Fig. 5 is a circuit diagram of selection circuit 16. In this example, paired output signals Da, D̄a and Db, D̄b from data input buffers 14a and 14b are sequentially supplied to eight pairs of write data lines WDI-1, W̄D̄Ī-1̄; WDI-2, W̄D̄Ī-2̄; WDI-3, W̄D̄Ī-3̄; WDI-4, W̄D̄Ī-4̄; WDII-1, W̄D̄Ī̄Ī-1̄; WDII-2, W̄D̄Ī̄Ī-2̄; WDII-3, W̄D̄Ī̄Ī-3̄; WDII-4, W̄D̄Ī̄Ī-4̄. The write data lines pairs are respectively connected to I/O line pairs.

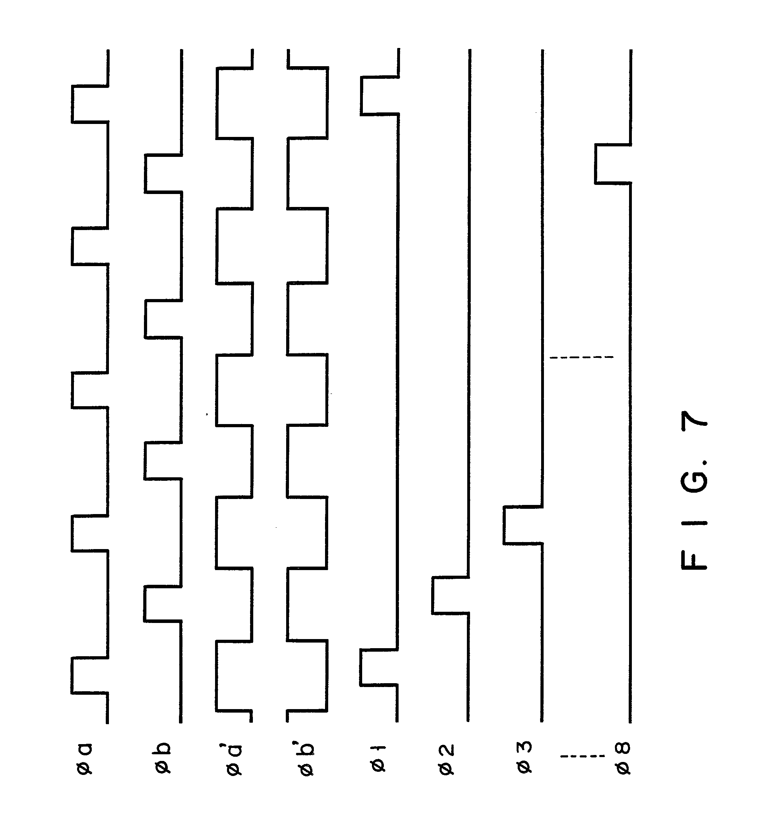

Paired output signals Da, D̄a and Db, D̄b from data input buffers 14a and 14b are supplied to AND gates 40 which are controlled by control signals φ1 to φ8. Outputs of AND gates 40 are input to clocked inverters 42 which are controlled by φa′ and φb′. Fig. 6 is a circuit diagram of clocked inverter 42. Clocked inverter 42 has two p-channel MOSFETs 52 and 54 and two n-channel MOSFETs 56 and 58 which are connected in series between power source Vdd and ground terminal Vss. An input signal (output of AND gate 40) is supplied to the gates of MOSFETs 52 and 58, and an output signal is supplied from the connection node between MOSFETs 54 and 56. Control signals $\overline{\phi a}'$ and $\phi a'$ (or $\overline{\phi b}'$ and $\phi b'$) are supplied to the gates of MOSFETs 54 and 56, respectively.

Outputs of clocked inverters 42 are supplied to write data line pairs WDI-1, $\overline{WDI-1}$ to WDII-4, $\overline{WDII-4}$ via buffers 44.

Next, the operation of selection circuit 16 is explained with reference to the timing chart of Fig. 7. Control signals $\phi a'$ and $\phi b'$ are complementary signals and are set to "H" level in a period including a period in which output signals are generated from data input buffers 14a and 14b. That is, clocked inverters 42 are set in a conductive state in given periods before and after the transfer period of data input buffer 14a or 14b connected to the input terminal. Control signals $\phi 1$ to $\phi 8$ are sequentially set to "H" level when control signals $\phi a$ and $\phi b$ supplied to data input buffers 14a and 14b are set to "H" level. That is, when data input buffers 14a and 14b have transferred the sensed data, AND gates 40 sequentially and selectively supply the sensed data to write data lines pairs WDI-1, $\overline{WDI-1}$ to WDII-4, $\overline{WDII-4}$.

First, when control signal $\phi a$ is at "H" level, control signal $\phi a'$ is at "H" level (or control signal $\phi b'$ is at "L" level) and control signal $\phi 1$ is at "H" level, outputs Da and $\overline{Da}$ of data input buffer 14a are output to write data lines WDI-1 and $\overline{WDI-1}$. In this case, if output data Da is at "H" level and $\overline{Da}$ is at "L" level, the levels of write data lines WDI-1 and $\overline{WDI-1}$ are respectively set to "H" and "L" levels.

After this, when control signal $\phi b$ is set to "H" level, control signal $\phi b'$ is set to "H" level (or control signals $\phi a'$ is set to "L" level) and control signal $\phi 2$ is set to "H" level, outputs Db and $\overline{Db}$ of data input buffer 14b are output to write data lines WDI-2 and $\overline{WDI-2}$. Further, when control signal $\phi 3$ is set to "H" level in the same manner as described above, next outputs Da and $\overline{Da}$ of data input buffer 14a are output to write data lines WDI-3 and $\overline{WDI-3}$. When control signal $\phi 8$ is set to "H" level, outputs Db and $\overline{Db}$ of data input buffer 14b are output to write data lines WDII-4 and $\overline{WDII-4}$, and after this, control signal $\phi 1$ is set to "H" level again so that outputs Da and $\overline{Da}$ of data input buffer 14a will be output to write data lines WDI-1 and $\overline{WDI-1}$.

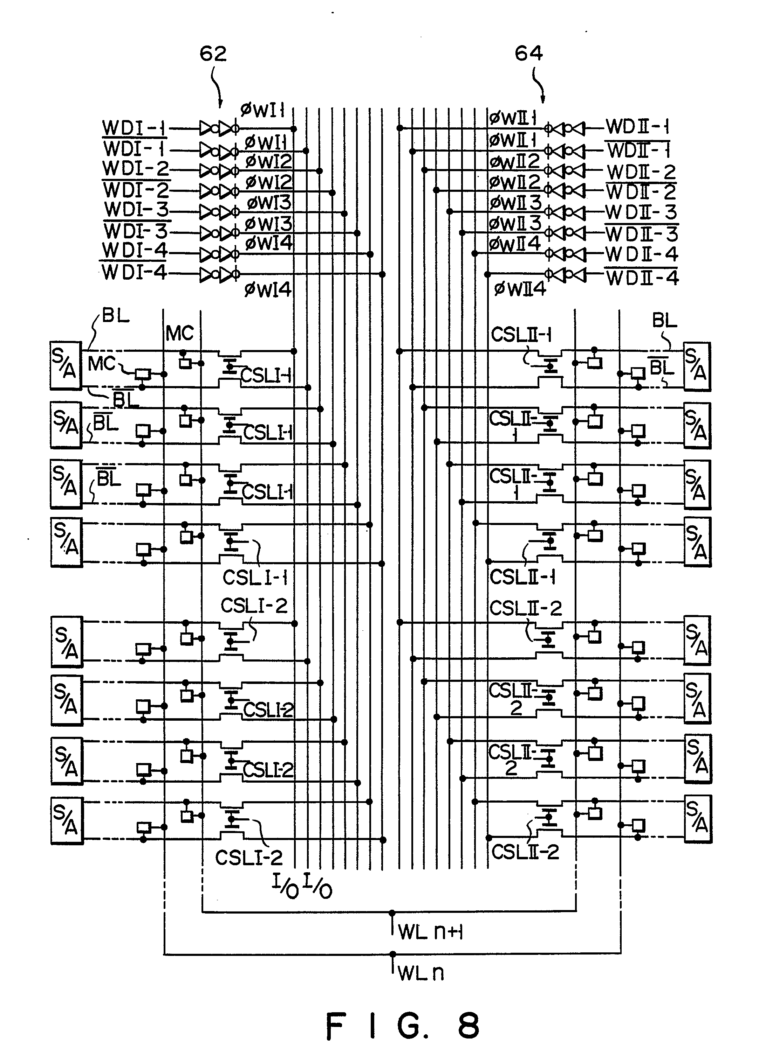

Fig. 8 is a circuit diagram of the memory cell area of a dRAM which is constituted by using the write-in circuit of the above construction so as to utilize a high speed nibble mode. The dRAM has memory cells of two planes called I-plane and II-plane, and data can be alternately written into the memory cells of the I-plane and II-plane and can be simultaneously written into four memory cells. Write data lines WDI-1, $\overline{WDI-1}$ to WDI-4, $\overline{WDI-4}$ are connected to I/O and $\overline{I/O}$ lines of the memory cells of the I-plane via gate stages 62 which are controlled by control signals $\phi wl1$ to $\phi wl4$. Likewise, write data lines WDII-1, $\overline{WDII-1}$ to WDII-4, $\overline{WDII-4}$ are connected to I/O and $\overline{I/O}$ lines of the memory cells of the II-plane via gate stages 64 which are controlled by control signals $\phi wII1$ to $\phi wII4$.

Four pairs of bit lines BL and $\overline{BL}$ are respectively connected to I/O and $\overline{I/O}$ lines of the I-plane memory cells via column selection lines CSLI-1, CSLI-2,.... Each bit line pair BL and $\overline{BL}$ is connected to dRAM cells MCs of one-transistor/one-capacitor construction and a sense amplifier S/A. Likewise, four pairs of bit lines BL and $\overline{BL}$ are respectively connected to I/O and $\overline{I/O}$ lines of the II-plane memory cells via column selection lines CSLII-1, CSLII-2,.... Each bit line pair BL and $\overline{BL}$ is connected to dRAM cells MCs of one-transistor/one-capacitor construction and a sense amplifier S/A. Further, dRAM cells MCs are connected to corresponding word lines WLs.

A reset circuit is connected to one end of I/O and $\overline{I/O}$ lines and a readout sense amplifier is connected to the other end of the I/O and $\overline{I/O}$ lines, although not shown in the drawing.

In the dRAM with the above construction, column selection lines CSLI-1 are first activated in the first cycle, thus simultaneously reading out four data from the four memory cells selected by the word line and connected to the four pairs of bit lines positioned in the left upper position in the drawing. The readout data are transferred via I/O and $\overline{I/O}$ lines. In contrast, new data supplied via the write-in circuit shown in Fig. 2 are sequentially written into the four sets of memory cells selected by the word line via I/O and $\overline{I/O}$ lines. In this case, while the write-in operation of the first cycle is being effected, the second cycle starts, i.e., the precharge operation for the memory cells for the II-plane is started, and CSLII-1 are activated to permit four-bit data to be simultaneously read out via I/O and $\overline{I/O}$ lines from the memory cells connected to the four pairs of bit lines positioned in the right upper position in the drawing. New data are sequentially written into the four sets of memory cells. Likewise, while the write-in operation of the second cycle is being effected, the third cycle starts, i.e., the precharge operation for the memory cells for the I-plane is started, and CSLI-2 are activated to permit four-bit data to be simultaneously read out from the memory cells connected to the four pairs of bit lines positioned in the second block from the above on the left side in the drawing. Further, new data are written into the four sets of memory cells. In this way, readout and write-in access operations are alternatingly and successively effected for four memory cells in each of the I-plane and II-plane selected by CSLI, CSLII, and WL with the successive cycles set partly overlapped.

In the conventional nibble mode, it is necessary to separately provide a precharge cycle between an access period of four bits and an access period of next four bits. Therefore, it is not possible to successively access five bits or more in high speed. However, according to this embodiment, the nibble mode can be substantially operated in a successive manner by dividing the memory cells into the I-plane and the II-plane and by alternatingly accessing the memory cells of the I-plane and the memory cells of the II-plane. That is, when the four bits are sequentially written into the memory cells in the I-plane, the four bits of memory cells in the II-plane are precharged and read out. Therefore, as many bits as desired can be successively accessed in a high speed.

When CSLI-1 are activated in the write-in operation, data of write-in data lines WDI-1 and $\overline{WDI\text{-}1}$ are transferred to bit lines BL and $\overline{BL}$ via the I/O and $\overline{I/O}$ lines at timings defined by control signal $\phi$WI1. Then, in the same manner, data of write-in data lines WDI-2 and $\overline{WDI\text{-}2}$ to WDI-4 and $\overline{WDI\text{-}4}$ are sequentially transferred to bit lines BL and $\overline{BL}$ at timings defined by control signals $\phi$WI2 to $\phi$WI4. After this, data is written into four memory cells MC connected to the word line which has been selected, for example, WLn. The same operation is repeatedly effected to sequentially write data of the write data lines into the memory cells.

This invention is not limited to the above embodiment. For example, the number of data input buffers is not limited to two and can be set to be more than two. Further, it is possible to supply outputs of a plurality of data output buffers to a single write data line.

As described above, according to this invention, a plurality of data input buffers which sense the level of an input signal, convert the input signal to a signal of MOS level and write the converted signal into the memory cell are operated in different timings so that a sufficiently long time can be set for the data input buffer to sense the level of the input signal even if the cycle of the input data is short. Therefore, the input data can be correctly sensed at a high speed and data can be written into the dRAM at a high speed.

## Claims

1. A semiconductor memory device comprising:
a data input pad;

a plurality of data input buffers connected in parallel with said data input pad and for sequentially sensing input data periodically input; and
selection means for receiving outputs from said plurality of data input buffers, sequentially selecting the outputs according to a cycle of the input data and supplying a selected output to a memory cell via a write data line.

2. A semiconductor memory device according to claim 1, characterized in that said plurality of data input buffers are respectively supplied with a plurality of control signals which are set in the same cycles as those of the input data and whose phases are shifted from one another, and said data input buffer includes means for sensing the input data of TTL (transistor-transistor-logic) level and converting the input data to data of MOS (metal-oxide-semiconductor) level and means for transferring the sensed MOS level data to said selection means in response to the control signal.

3. A semiconductor memory device according to claim 2, characterized in that said data input buffer further includes means for resetting the sensed data after a predetermined time in response to the control signal.

4. A semiconductor memory device according to claim 1, characterized in that said selection means sequentially selects one of outputs of said plurality of data input buffers and sequentially supplies the selected data to a corresponding one of a plurality of write data lines.

5. A semiconductor memory device according to claim 4, characterized in that said selection means includes first gate means connected to said plurality of write data lines to receive all the outputs of said plurality of data input buffers and to be sequentially turned on in each cycle of the control signal supplied to said data input buffer and second gate means for receiving each of outputs of said first gate means and selecting an output of that one of said data input buffers which is supplied with the control signal.

6. A semiconductor memory device comprising:
memory cell groups of first and second planes;
2m I/O (input/output) lines. m I/O lines being provided for each of the first and second planes;
bit lines connected to said I/O lines, each of the bit lines being connected to a number of dRAM cells;
2m write data lines respectively connected to said 2m I/O lines;
a plurality of data input buffers connected to a data input pad to sequentially sense input data periodically input; and
selection means for receiving outputs of said plurality of data input buffers, sequentially selecting the outputs and transferring the selected output to a corresponding one of a plurality of write data lines.

7. A semiconductor memory device according to claim 6, characterized in that said bit lines in each of the first and second planes include n groups of m bit lines, said m bit lines of each group are connected to said m I/O lines via a corresponding one of column selectors; and said column selectors connected to said m bit lines are sequentially activated to alternately select said memory call groups of first and second planes.

8. A semiconductor memory device according to claim 6, characterized in that said write data lines are connected to said I/O lines via gate stages which are sequentially turned on each time data is transferred from said selection means.

9. A semiconductor memory device according to claim 6, characterized in that said selection means includes 2m AND gate means provided correspondingly to said 2m number of write data lines to receive all the outputs of said plurality of data input buffers and to be sequentially turned on each time each of said data input buffers is operated; and gate means connected to receive outputs of said AND gate means and provided correspondingly to said plurality of data input buffers, and for selecting an output of that one of said data input buffers which is in operation and supplying the output to a corresponding one of said 2m data lines.

EP 0 317 963 A2

2   3   4   WRITE DATA LINE 5

INPUT PAD 1 — PROTECTION CIRCUIT → DATA INPUT BUFFER → SELECTION CIRCUIT → TO MEMORY CELL

ø

F I G. 1

øa   ød, øb

12   DATA INPUT BUFFER 14a   SELECTION CIRCUIT 16   WRITE DATA LINE 18

INPUT PAD 10 — PROTECTION CIRCUIT → → TO MEMORY CELL

DATA INPUT BUFFER

øb   14b

ø1 ~ ø8

F I G. 2

F I G. 3

F I G. 6

EP 0 317 963 A2

F I G. 4

F I G. 5

F I G. 7

F I G. 8